# EUROPÄISCHE PATENTANMELDUNG

(11) **EP 1 002 887 A1**
(43) Veröffentlichungstag der Anmeldung: **24.05.2000**
(21) Anmeldenummer: 99203791.1
(22) Anmeldetag: 11.11.1999
(51) Int. Cl.: C23C 14/54, H01J 9/22

(54) **Verfahren und Anordnung zur Herstellung einer Leuchtschicht**

(30) Priorität: 20.11.1998 DE 19853605
(71) Anmelder: Philips Corporate Intellectual Property GmbH, 52064 Aachen (DE); Koninklijke Philips Electronics N.V., 5621 BA Eindhoven (NL)
(72) Erfinder: Wieczorek, Herfried, 52064 Aachen (DE); Van de Vorst, Michel, 52064 Aachen (DE)
(74) Vertreter: Gössmann, Klemens

(57) **Zusammenfassung**

Bei einem Verfahren und einer Anordnung zur Herstellung einer Leuchtschicht auf einem Substrat (12), welches von einem Substrathalter (11) gehalten wird, wird die Temperatur von Substrat (12) und Substrathalter (11) geregelt, indem zur Wärmekopplung zwischen Substrat und Substrathalter ein Gas in einem Hohlraum (14) zwischen Substrat und Substrathalter verwendet wird.

## Beschreibung

Es wird ein Verfahren und eine Anordnung zur Herstellung einer Leuchtschicht auf einem Substrat, welches von einem Substrathalter gehalten wird und die Temperatur von Substrat und Substrathalter geregelt wird, angegeben.

Derartige Leuchtschichten werden zur Umwandlung von Röntgenstrahlung in sichtbares oder ultraviolettes Licht für Röntgendetektoren verwendet.

In der DE 195 19 775 A1 wird ein Verfahren zur Herstellung dotierter Alkalihalogenidaufdampfschichten beschrieben. Hier wird die Alkalihalogenidschicht und der Dotierstoff mittels zweier Verdampfer auf ein rotierendes Substrat aufgebracht. Der Aufdampfprozeß erfolgt bei einem Druck von ca. 10⁻³ Pascal im Vakuum. Die Temperatur des Substrats wird mit einer Heizlampe und einem Kühlblech geregelt, die über dem Verdampfer und dem Substrat angeordnet sind.

Bei der Bedampfung von Substraten zur Herstellung von Detektoren ist es besonders wichtig, eine gleichmäßige Temperaturverteilung auf dem gesamten Substrat zu realisieren, um eine homogene Leuchtschicht zu erhalten. Eine Überhitzung des Substrates während des Aufdampfprozesses würde die Eigenschaften der Leuchtschicht, insbesondere Lichtausbeute und Ortsauflösung, nachteilig beeinflussen.

Aufgabe der Erfindung ist es deshalb, ein Verfahren und eine Anordnung anzugeben, bei denen die starke Aufheizung des Substrates während des Bedampfungsprozesses geregelt wird.

Diese Aufgabe wird dadurch gelöst, daß zur Wärmekopplung zwischen Substrat und Substrathalter ein Gas in einem Hohlraum zwischen Substrat und Substrathalter vorgesehen ist.

Zwischen dem Substrathalter und dem von diesem gehaltenen Substrat ist eine flacher Hohlraum vorgesehen. Während des Bedampfungsprozesses wird das Substrat mechanisch gegen den Substrathalter gepreßt. Die Bedampfung des Substrats mit der Leuchtschicht erfolgt im Vakuum. Nach dem Abpumpen der gesamten Depositionskammer ist dieser Hohlraum oder die Vertiefung ebenfalls evakuiert. Dieser Hohlraum wird von der Depositionskammer vakuumtechnisch getrennt. Der so entstandene abgeschlossene Hohlraum zwischen dem Substrat und dem Substrathalter wird mit einem von außen zugeführten Gas gefüllt. Als vorteilhaft erweist sich hierbei ein Gas mit niedrigem Molekulargewicht. Insbesondere kann Helium verwendet werden, welches sich durch geringes Gewicht und sichere Handhabung im Gegensatz zu Wasserstoff auszeichnet. Dieses Gas wird unter entsprechendem Druck in den Hohlraum geleitet. Für den Druck, mit dem das Gas in den Hohlraum geleitet wird, muß ein Kompromiß zwischen einer geringen Durchbiegung des Substrats und einer guten Wärmekopplung zwischen Substrat und Substrathalter gefunden werden.

Als vorteilhaft kann vorgesehen sein, daß das einzuleitende Gas einen Druck < 10 mbar aufweist. Mit einem Druck von etwa 5 bis 10 mbar kann eine ausreichende Wärmeleitung sichergestellt werden und einem Durchbiegen des Substrates, auf Grund des Vakuums, entgegengewirkt werden. Durch die Kontrolle der Substrattemperatur wird eine Überhitzung des Substrates, insbesondere der Detektorstrukturen, verhindert.

Bei einer Ausgestaltung der Erfindung erweist es sich als vorteilhaft, daß die Leuchtschicht aus einer mit Thallium (Tl) dotierten Cäsiumiodidschicht (Cs:I) besteht. Durch die Temperaturregelung mit dem Heliumgas wird eine konstante Substrattemperatur erreicht, die ein gleichmäßiges Wachsen der Alkalihalogenidnadeln ermöglicht. Andere Gase, wie z.B. Stickstoff oder Gasverbindungen, sind auch einsetzbar, sofern sie eine gute Wärmekopplung ermöglichen. Durch die Temperaturregelung werden ideale Wachstumsbe-. dingungen bereitgestellt, die eine Erzeugung von Leuchtschichten mit hoher Lichtausbeute und guter Ortsauflösung ermöglichen.

Beim Aufdampfen von Szintillatorschichten oder Leuchtschichten steigt die Temperatur des Substrates stark an, so daß es zu Schäden am Detektor kommen kann- Heiß aufgedampfte Leuchtschichten weisen eine geringe Ortsauflösung auf. Durch die hohen Temperaturen verändert sich auch die Nadelstruktur der Leuchtschicht, so daß die Ortsauflösung des Detektors stark vermindert wird. Außerdem kann bei starker Aufheizung der Dotierstoff teilweise aus der aufgedampften Leuchtschicht re-sublimieren, so daß sich die Lumineszenzeigenschaften der Leuchtschicht nachteilig verändern und sich in geringer Lichtausbeute und lang anhaltendem Nachleuchten niederschlagen. Kalt aufgedampfte Leuchtschichten wachsen amorph auf und lumineszieren schlecht oder gar nicht.

Die Einhaltung eines bestimmten Temperaturbesreiches bei der Herstellung derartiger Leuchtschichten ist für die Qualität des Röntgendetektors und auch der später produzierten Röntgenbilder sehr wichtig. Je höher die Lichtausbeute der Leuchtschicht ist, desto weniger Röntgenstrahlung muß eingesetzt werden, um ein akzeptables Röntgenbild zu erhalten.

Mit diesem erfindungsgemäßen Verfahren läßt sich die Temperatur für die Keimschicht und für eine Volumenschicht separat einstellen, so daß die Ortsauflösung und die Lichtausbeute der Leuchtschicht getrennt optimiert wird.

Nachfolgend wird ein Ausführungsbeispiel anhand der Zeichnungen näher erläutert.
Fig. 1 zeigt eine Depositionskammer,
Fig. 2 zeigt eine schematischen Aufbau von Substrat und Substrathalter.

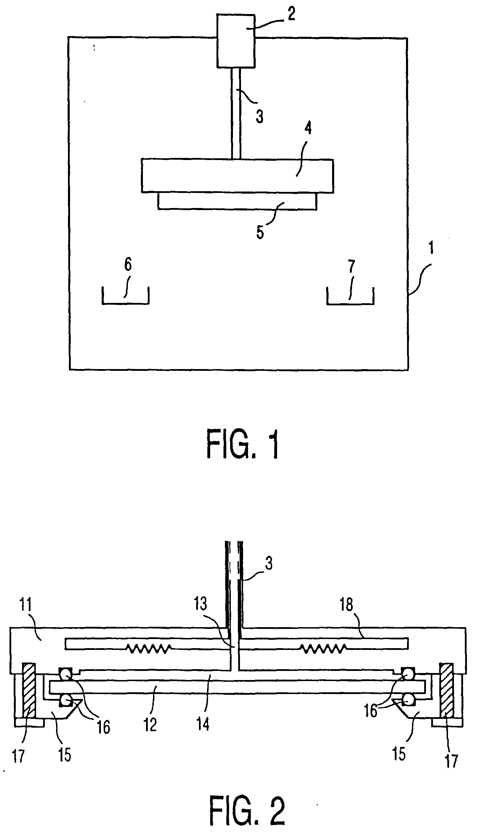

In Fig. 1 wird eine Aufdampfanlage dargestellt, die aus einer Depositionskammer 1 und einem Substrathalter 4 besteht, an dem ein Substrat 5 angebracht ist. Über eine hier nicht dargestellte Leitung in einer Antriebswelle 3 wird ein Gas zum Temperieren des Substrathalters 4 und des Substrats 5 zugeführt. Der Substrathalter 4 und das von diesem gehalterten Substrat 5 werden mit einem Antrieb 2 während des Bedampfungsprozesses in eine Drehbewegung versetzt. Mit 6 und 7 sind Verdampfer bezeichnet, in denen beispielsweise in 6 Cäsiumiodid und in 7 Thalliumiodid enthalten ist. Diese beiden Verdampfer werden über eine separat; nicht dargestellte Heizung aufgeheizt, bis der enthaltene Stoff seinen Schmelzpunkt erreicht, bei höherer Temperatur verdampft bzw. sublimiert und sich auf das drehende Substrat ablagert. Das Substrat 5, welches vom Substrathalter 4 gehaltert wird, besteht vorzugsweise aus Glas. Auf dieses Glas werden ein Alkalihalogenid, beispielsweise Cäsiumiodid und als Dotierstoff z.B. Thalliumiodid aufgedampft. Der Substrathalter ist beispielsweise aus Aluminium gefertigt.

Fig. 2 zeigt den Substrathalter 11, das Substrat 12, Anpreßbacken 15, Dichtringe 16, einen Hohlraum 14, Verschraubungen 17, eine elektrische Heizung 18 und eine Leitung 13 in der Antriebswelle 3. Im Substrathalter 11 ist eine beispielsweise elektrische Heizung 18 angeordnet. An diesem Substrathalter 11 sind Anpreßbacken angeordnet, die mit dem Substrathalter 11 über Schrauben 17 verschraubt sind. Das Substrat 12, das üblicherweise aus Glas besteht, ist auf Dichtringen 16 gelagert, die auf einer Seite in den Anpreßbacken 15 angeordnet sind und auf der anderen Seite des Substrats im Substrathalter 11 angeordnet sind.

In den Verdampfern 6 und 7 sind die aufzudampfenden Stoffe enthalten. Diese werden über getrennte Heizungen zum Schmelzen gebracht. Mit der Größe der Öffnung des Verdampfers und dem Winkel, in dem die Verdampfer zum Substrat 12 angeordnet sind, läßt sich die Bedampfungsmenge des Cs:I und des Tl:I einstellen. Der Bedampfungsprozeß wird im Vakuum vorgenommen. Dazu wird die Depositionskammer 1 evakuiert. Danach wird das Substrat mit den Anpreßbacken 15 an den Substrathalter gepreßt. Durch die Dichtringe 16 entsteht der vom übrigen Vakuum getrennte Hohlraum 14. Der Substrathalter und das Substrat werden über die Heizung 18 vorgeheizt, um schnell in den idealen Temperaturbereich zu kommen. Für mit Tl dotiertes Cs:I erweist es sich als vorteilhaft, den Bedampfungsprozeß in einem Bereich von 180-220°C vorzunehmen. Um diese Temperatur während des gesamten Herstellungsprozesses der Leuchtschicht einzuhalten, erfolgt eine Wärmekopplung zwischen Substrat und dem Substrathalter mit dem über die Leitung 13 in der Antriebswelle 3 in den Hohlraum 14 zugeführten temperierten Heliumgas.

Das temperierte Heliumgas wird in diesen Hohlraum 14 eingeleitet und ein Druck < 10 mbar eingestellt. Bei großen Substraten, die sich durch den Druck in Richtung Depositionskammer durchbiegen, muß ein entsprechend niedriger Druck diese Durchbiegung verhindern. Andererseits nimmt die Wärmeleitfähigkeit bei zunehmendem Druck zu, so daß zwischen Durchbiegung und entsprechender Wärmekopplung ein Kompromiß gefunden werden muß. Mit dem angegebenen Druck von < 10 mbar läßt sich eine gleichmäßige Temperierung realisieren, bei der eine homogene Leuchtschicht mit maximaler Lichtausbeute herstellbar ist. Der Hohlraum, der mit dem Helium gefüllt wird, ist an einen nicht dargestellten Kreislauf angeschlossen, so daß ein ständiger Gasstrom für die gleichmäßige Einstellung des Druckes sorgt und somit eine konstante Temperatur für den Bedampfungsprozeß unter gleichmäßigen Druckverhältnissen realisiert wird.

## Patentansprüche

1. Verfahren zur Herstellung einer Leuchtschicht auf einem Substrat (12), welches von einem Substrathalter (11) gehalten wird und die Temperatur von Substrat (12) und Substrathalter (11) geregelt wird, dadurch gekennzeichnet,
daß zur Wärmekopplung zwischen Substrat und Substrathalter ein Gas in einem Hohlraum (14) zwischen Substrat und Substrathalter verwendet wird.

2. Verfahren zur Herstellung einer Leuchtschicht nach Anspruch 1, dadurch gekennzeichnet,
daß das einzuleitende Gas eine Temperatur von 100 bis 350°C aufweist und mit einem Druck ≤ 10 mbar die Durchbiegung des Substrates (12) und die Wärmekopplung zwischen Substrat (12) und Substrathalter (11) einstellbar ist.

3. Verfahren zur Herstellung einer Leuchtschicht nach Anspruch 1, dadurch gekennzeichnet,
daß die Leuchtschicht aus einer mit Thallium dotierten Cäsiumiodidschicht besteht.

4. Verfahren zur Herstellung einer Leuchtschicht nach Anspruch 1, dadurch gekennzeichnet,
daß als Gas ein Gas mit niedrigem Molekulargewicht, insbesondere Helium, verwendet wird.

5. Anordnung zur Herstellung einer Leuchtschicht auf einem Substrat (12), welches vor einem Substrathalter (11) gehalten wird, dadurch gekennzeichnet, daß zwischen Substrat (12) und Substrathalter (11) ein Hohlraum (14) vorgesehen ist, der durch Anpressen des Substrats an den Substrathalter und einer Abdichtung mittels Dichtringen (16) gebildet wird und dieser Hohlraum (14) über eine Leitung (13) füllbar ist.
